# EUROPEAN PATENT APPLICATION

(11) **EP 2 571 213 A1**
(43) Date of publication of application: **20.03.2013**
(21) Application number: 11780340.3
(22) Date of filing: 13.04.2011
(51) Int. Cl.: H04L 25/02, H01L 23/50, H04B 3/02

(54) **DIFFERENTIAL SIGNAL TRANSMISSION LINE, IC PACKAGE, AND METHOD FOR TESTING SAID DIFFERENTIAL SIGNAL TRANSMISSION LINE AND IC PACKAGE**

(30) Priority: 12.05.2010 JP 2010110220
(71) Applicant: Panasonic Corporation, Kadoma-shi Osaka 571-8501 (JP)
(72) Inventor: MASUDA, Kohei, Osaka-shi, Osaka 540-6207 (JP); SHIBATA, Osamu, Osaka-shi, Osaka 540-6207 (JP); SUENAGA, Hiroshi, Osaka-shi, Osaka 540-6207 (JP); SAITO, Yoshiyuki, Osaka-shi, Osaka 540-6207 (JP)
(74) Representative: Eisenführ, Speiser & Partner
(86) International application number: PCT/JP2011/002188
(87) International publication number: WO 2011/142079

(57) **Abstract**

An IC package (50) includes an integrated circuit (10) for transmitting and receiving a pair of differential signals composed of a signal having positive polarity and a signal having negative polarity, a first signal terminal (41a) for transmitting the signal having positive polarity, a second signal terminal (41b) for transmitting the signal having negative polarity, and a third terminal (43) arranged between the first signal terminal and the second signal terminal. The first and second terminals are electrically connected to the integrated circuit, and the third terminal (43) is not electrically connected to the integrated circuit.

## Description

### Technical Field

The present invention relates to a differential signal transmission line having terminals for transmitting differential signals, an IC package having such a transmission line and a testing method thereof.

### Background Art

In recent years, interfaces for transmitting data between devices or inside a device are being increasingly sped up, and high-speed digital interfaces that enable transmission of Giga bit order have being mainly used. Typical high-speed digital interfaces include SATA (Serial ATA), USB 3.0 and the like.

With a digital signal sped up more, a signal cycle becomes shorter so that a timing margin on a time domain reduces. Therefore, influences of noises caused inside and outside the device become prominent, resulting in deterioration in a receiving performance. In view of immunity of the noises, a differential transmission system is employed in a lot of high-speed digital interfaces. The differential transmission system is a transmission system for transmitting a differential signal composed of positive and negative complementary signals. In the differential transmission system, magnetic field of a positive signal and magnetic field of a negative signal are cancelled each other, resulting in low noise emission. Further, since a signal is received with a difference between a positive signal and a negative signal, an external noise is cancelled, resulting in high noise immunity.

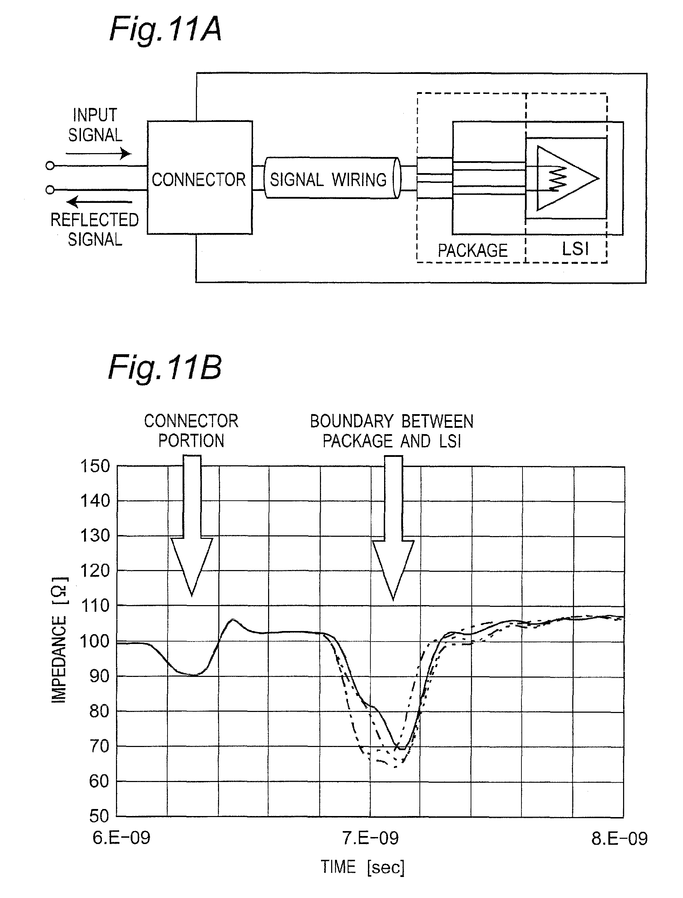

Therefore, for a transmission apparatus compatible with the high-speed digital interface using the differential transmission system, it needs to appropriately design the entire apparatus to achieve suitable noise immunity. Specifically, in case of an apparatus including a connector, a signal wiring, an IC package and an LSI as shown in Fig. 11A, it is necessary to adjust characteristic impedance among elements including the connector, the wiring, the IC package and the LSI and to conform a wiring length of a positive signal with a wiring length of a negative signal in order to achieve satisfactory noise immunity.

However, it is considered that when the respective elements are designed insufficiently or are influenced by a large external noise, quality of the differential signal is deteriorated. Therefore, a method of testing a receiving performance of a LSI for receiving a signal is necessary.

Further, these high-speed digital interfaces have a problem of a return loss. The return loss (reflection loss) is a power ratio between an incident wave and a reflected wave, generally expressed by decibel. In recent years, a return loss regulation is introduced to the high-speed digital interfaces, requiring suppression of the return loss within predetermined values.

Therefore, regarding the transmission apparatus compatible with the high-speed digital interfaces, it is necessary to suitably design the entire apparatus so that the apparatus complies with the return loss regulation. Concretely, in the case of the apparatus composed of the connector, the wiring, the IC package and the LSI as shown in Fig. 11A, it is necessary to match the characteristic impedance among the elements including the connector, the wiring, the IC package and the LSI in order to achieve satisfactory return loss characteristic.

The invention relating to the IC package for transmitting differential signals is disclosed in the following prior art documents.

### Prior Art Documents

### Patent Documents

Patent Document 1: JP2009-267227A
Patent Document 2: JP2009-004628A
Patent Document 3: JP2006-262460A

### Disclosure of Invention

### Problems to be Solved by the Invention

However, those documents do not disclose a method of testing the noise immunity of the single LSI. Further, it is difficult to match the characteristic impedance among the elements in an actual apparatus, and generally as shown in Fig. 11B, the characteristic impedance fluctuates at connecting sections between the elements. For example, in Fig. 11B, the characteristic impedance is greatly deteriorated near the connecting section between the IC package (a lead frame and a bonding wire) and the LSI.

The deterioration in the characteristic impedance near the connecting section between the IC package and the LSI causes a deterioration in the return loss characteristic, resulting in a problem that the return loss regulation can not be observed.

The present invention is devised in order to solve the above problem, and its object is to provide a differential signal transmission line capable of improving the characteristic impedance of a transmission line and achieving a satisfactory return loss characteristic, and an IC package having the differential signal transmission line. Further, it is an object of the present invention to provide a transmission line structure for evaluating noise immunity of single LSI using the IC package and a connector, and its testing method.

### Means for Solving the Problem

An IC package according to the present invention includes an integrated circuit for transmitting and receiving a pair of differential signals composed of a signal having positive polarity and a signal having negative polarity, a first signal terminal for transmitting the signal having positive polarity, a second signal terminal for transmitting the signal having negative polarity, and a third terminal arranged between the first signal terminal and the second signal terminal. The first and second terminals are electrically connected to the integrated circuit, and the third terminal is not electrically connected to the integrated circuit.

A differential signal transmission line according to the invention is a device for transmitting a pair of differential signals composed of a first differential signal and a second differential signal, and includes a first signal terminal for transmitting the first differential signal, a second signal terminal for transmitting the second differential signal, and a third terminal that is arranged between the first signal terminal and the second signal terminal and is not connected to any electric potential.

A first testing method according to the present invention is a testing method of the IC package or the differential signal transmission line, and includes applying a noise signal for the test to the terminal connected to nothing, and evaluating a receiving performance when applying the noise signal to the third terminal to evaluate common mode noise immunity.

A second testing method according to the present invention is a testing method of the IC package or the differential signal transmission line, and includes applying ESD to the third terminal, and evaluating a receiving performance when applying ESD to the third terminal to evaluate ESD immunity.

A third testing method according to the present invention is a testing method of the IC package or the differential signal transmission line, and includes connecting the third terminal to a ground potential via a resistor, applying differential signals for test to the first and second signal terminals, measuring a voltage generated at the resistor connected to the third terminal, and evaluating a skew of the differential signals based on the measured voltage.

### Effect of the Invention

According to the IC package or the differential signal transmission line of the present invention, the third terminal is provided between the differential signal terminals, so that a gap between the differential signal terminals can be widened to reduce a coupling capacitance and a mutual inductance between the signal terminals, thus raising characteristic impedance of the differential signal transmission line. As a result, the return loss characteristic of the differential signal transmission line can be improved. Further, according to the IC package or the differential signal transmission line of the present invention, the third terminal can be used as a test terminal for evaluating the performances of the IC package or the differential signal transmission line, thereby enabling various tests.

### Brief Description of Drawings

Fig. 1A is a diagram illustrating a configuration of an IC package as one embodiment of a differential signal transmission line (or a differential signal transmission apparatus) according to the present invention, and Fig. 1B is a diagram describing an arrangement of connecting terminals relating to differential transmission in the IC package according to a first embodiment.
Fig. 2 is a diagram describing a common mode noise applying test of a differential signal using an NC terminal.
Fig. 3 is a diagram describing an ESD applying test of a differential signal using the NC terminal.
Fig. 4 is a diagram describing an intra-skew evaluation test of a differential signal using the NC terminal.
Fig. 5 is a diagram illustrating a result of measuring an impedance characteristic of the IC package.
Fig. 6 is a diagram illustrating a result of measuring a return loss characteristic of the IC package.
Fig. 7 is a diagram describing a usage state of the NC terminal with the IC package grounded.
Fig. 8 is a diagram describing the IC package providing with a plurality of NC terminals.
Fig. 9 is a diagram describing a layout of the NC terminal arranged on a position separated equally from two differential signal terminals.
Figs. 10A and 10B are diagrams describing terminals of a connector as one embodiment of the differential signal transmission line (or the differential signal transmission apparatus) according to the present invention.
Fig. 11A is a diagram illustrating a configuration of a conventional transmission apparatus compatible with high-speed digital interfaces, and Fig. 11B is a diagram describing a problem of the return loss characteristic.

### Mode for Carrying Out the Invention

Embodiments of the present invention will be described below with reference to the accompanying drawings.

### First Embodiment

### 1. Configuration of IC Package

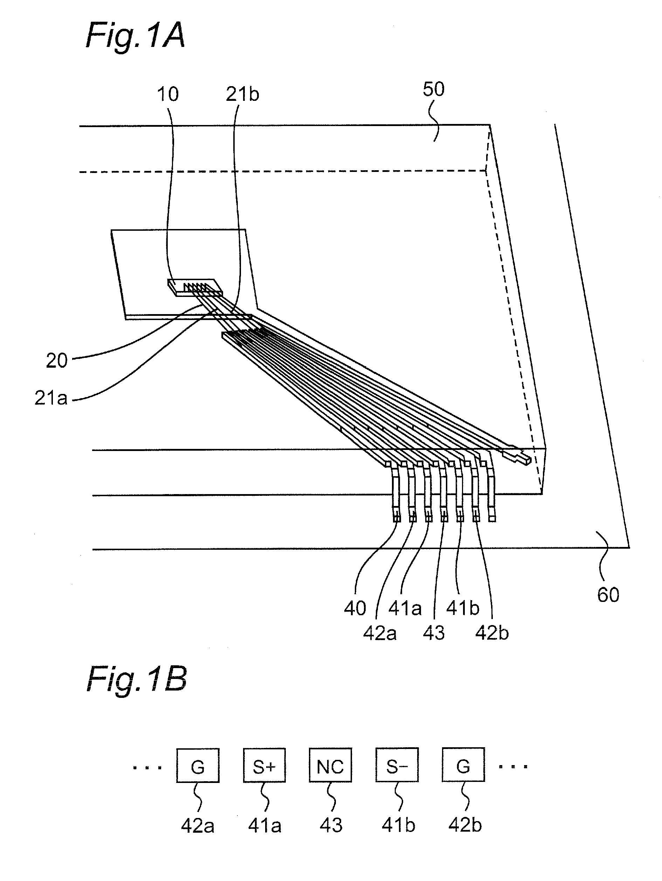

Fig. 1A is diagram illustrating a configuration of an IC package as one embodiment of a differential signal transmission line (or a differential signal transmission apparatus) according to the present invention. The IC package 50 according to the embodiment includes an LSI chip 10 internally. The LSI chip 10 has a plurality of terminals (not shown), and the respective terminals are connected to lead frames 40, 41a, 41b, ... via bonding wires 20, 21a, 21b, .... For convenience of the explanation, Fig. 1A illustrates only a part of connecting terminals of the IC package 50.

The IC package 50 is molded by resin, and the LSI chip 10, the bonding wires 20, 21a, 21b, ..., and a part of the lead frames 40, 41a, 41b, ... are sealed thereinto. A portion of the lead frames 40, 41a, 41b, ..., exposed outside the resin mold functions as a connecting terminal used for mounting the IC package 50 on a printed circuit board 60.

The LSI chip 10 according to the embodiment is compatible with an interface which enables high-speed signal transmission by using differential signals, such as SATA (Serial-ATA), and USB 3.0 and thus the IC package 50 has signal terminals for transmitting differential signals. Fig. 1B is a diagram describing a layout of the connecting terminals relating to the transmission of the differential signals in the IC package 50 according to the embodiment. Connecting terminals 41a and 41b are terminals for transmitting differential signals, and the connecting terminal 41a transmits a positive differential signal (S+), and the connecting terminal 41b transmits a negative differential signal (s-), respectively. Further, the connecting terminals 42a and 42b are terminals which are to be connected to a reference potential. Hereinafter, the connecting terminals 41a and 41b are referred to as "differential signal terminals", and the connecting terminals 42a and 42b are referred to as "ground terminals".

Particularly in the embodiment, a terminal 43 is provided between the differential signal terminal 41a and the differential signal terminal 41b. The terminal 43 is a terminal that is not connected to any electric potentials (hereinafter, this terminal is referred to as "NC terminal"). Specifically, the differential signal terminals 41a and 41b (namely, the lead frames 41a and 41b), the ground terminals 42a and 42b (namely, the lead frames 42a and 42b), and the like are connected to the respective terminals of the LSI chip 10 via the bonding wires 21a, 21b, ..., while the NC terminal 43 (namely, the lead frame 43) is not connected to any terminals nor any nodes of the LSI chip 10. Such an NC terminal 43 provided between the differential signal terminals 41a and 41b can improve a return loss characteristic (The details will be described later).

Since the NC terminal 43 is provided, an influence of a noise to be applied to the NC terminal 43 is feared. However, in this embodiment, the NC terminal 43 is not connected to any terminal of the LSI chip 10. For this reason, even if a noise is applied to the NC terminal 43, the noise is prevented from being transmitted to the LSI chip 10. Further, even though a noise applied to the NC terminal 43 is transmitted to the differential signal terminal 41a and the differential signal terminal 41b via coupling between the NC terminal 43 and the differential signal terminals 41a and 41b, the noise is cancelled in the apparatus that receives the differential signal due to a differential signal characteristic.

In this embodiment, the NC terminal 43 (the lead frame 43) is not connected to the bonding wire. However if the bonding wire is not connected to any electric potentials in the LSI, the NC terminal 43 (the lead frame 43) may be connected to the bonding wire.

### 2. Various Tests on the IC Package Using the NC Terminal

The NC terminal 43 of the IC package 50 according to the embodiment is used, as a non-connecting terminal, in a state where it is not connected to any electric potentials (nodes) during normal use. However during a predetermined test for evaluating a performance of the IC package, the NC terminal 43 may be used as a test terminal. The test method using the NC terminal 43 as a test terminal will be described below.

### 2.1 Common Mode Noise Application Test on Differential Signal

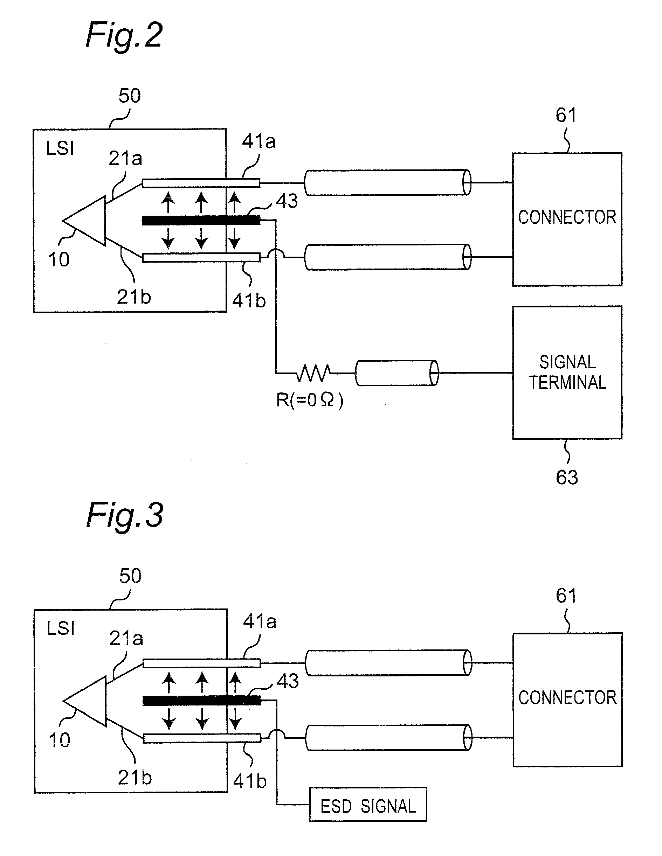

With reference to Fig. 2, a common mode noise application test on a differential signal in the IC package 50 will be described.

A signal terminal 63 is connected to the NC terminal 43 via a resistor R of 0 Ω, and a connector 61 is connected to the differential signal terminals 41a and 41b. A noise signal is applied to the NC terminal 43 via the signal terminal 63. As a result, a common mode noise is applied from the NC terminal 43 (namely, the lead frame 43) to the two differential signal terminals 41a and 41b (namely, the lead frames 41a and 41b). In this state, a receiving performance is evaluated so that common mode noise immunity of the LSI is evaluated.

As described above, for the IC package 50 according to the embodiment, the NC terminal 43 is connected to nothing in normal use. On the other hand, in he common mode noise immunity test, the resistor R is connected to the NC terminal 43 and the NC terminal 43 is used as a test terminal to which a noise is applied, thus enabling evaluation of the common mode noise immunity.

### 2.2 ESD Application Test on Differential Signal

With reference to Fig. 3, the ESD application test on the IC package 50 will be described.

ESD (Electrostatic Discharge) is applied to the NC terminal 43 with an ESD gun or the like, so that ESD is applied from the lead frame 43 of the NC terminal to the lead frames 41a and 41b of the two differential signal terminals. In this state, the receiving performance is evaluated so that ESD immunity of the LSI can be evaluated.

In this manner, for the IC package 50 according to the embodiment, in the normal use, nothing is connected to the NC terminal 43. In the ESD immunity test, the NC terminal 43 is used as a test terminal to which the ESD is applied, so that the ESD immunity test can be conducted.

### 2.3. Intra-Skew Evaluation Test on Differential Signal

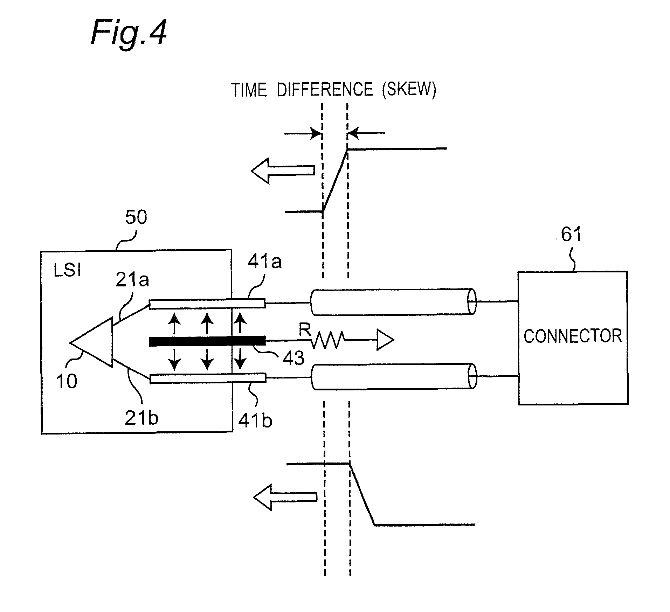

With reference to Fig. 4, an intra skew evaluation test on a differential signal in the IC package 50 will be described. The intra skew means a time difference (skew) between a positive differential signal (S+) and a negative differential signal (S-).

The NC terminal 43 is connected to a ground via the resistor R. The differential signals (S+ and S-) are applied to the differential signal terminals 41a and 41b, respectively. When the differential signals transmitted through the differential signal terminals 41a and 41b do not have difference from each other, a voltage is not generated across the resistor R connected to the NC terminal 43. However, when a time difference (skew) exists between the differential signals transmitted through the differential signal terminals 41a and 41b, a voltage is generated across the resistor R for the time difference. By measuring the generated voltage, it is possible to evaluate intra skew of the differential signals.

When there is no time difference (skew) between the signals transmitted through the differential signal terminals 41a and 41b, an influence of an electric field at the differential signal terminal 41a and an influence of an electric field at the differential signal terminal 41b cancel each other on the NC terminal 43, so that a voltage is not generated across the resistor R. However, when there is a time difference (skew) between the signals transmitted through the differential signal terminals 41a and 41b, the influence of the electric field at the differential signal terminal 41a and the influence of the electric field at the differential signal terminal 41b do not cancel each other for the time difference, so that a voltage is generated across the resistor R connected to the NC terminal 43. Therefore, by measuring the voltage generated across the resistor R, the intra skew can be evaluated.

In this manner, for the IC package 50 according to the embodiment, nothing is connected to the NC terminal 43 in normal use, while in the intra skew evaluation the NC terminal 43 is used as a test terminal so that the intra skew can be evaluated.

### 3. Characteristic Impedance of the IC Package Using the NC Terminal

The IC package 50 according to the embodiment has the NC terminal 43 provided between the differential signal terminals 41a and 41b. By this arrangement, a distance between the differential signal terminals 41a and 41b, namely, the lead frames 41a and 41b can be secured to be longer compared to a case where no NC terminal 43 is provided. Therefore, a coupling capacitance and a mutual inductance between these terminals (the lead frames) 41a and 41b can be further reduced, and the characteristic impedance of the IC package 50 can be raised, thereby improving the return loss characteristic.

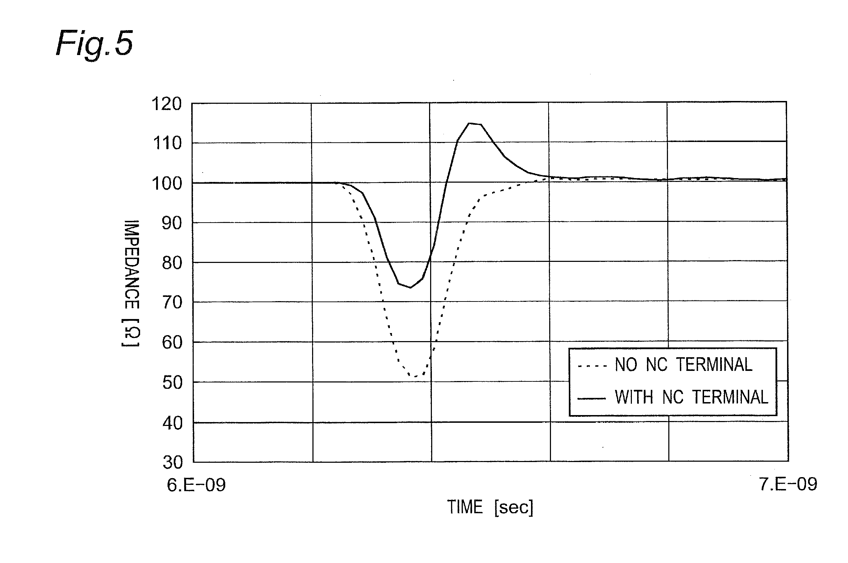

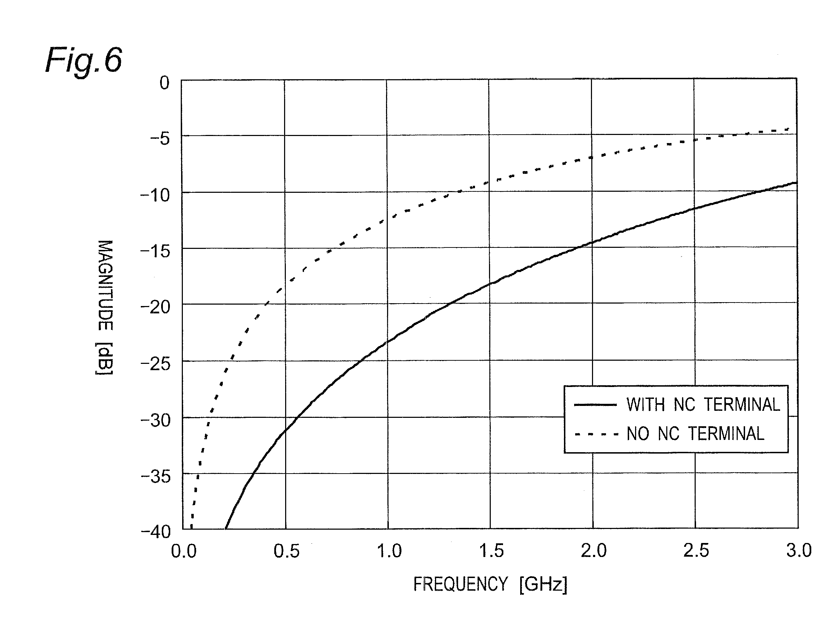

Fig. 5 is a diagram illustrating measurements of the impedance characteristic of the IC package. Further, Fig. 6 is a diagram illustrating measurements of the return loss characteristic in the IC package. In Figs. 5 and 6, a solid line represents a characteristic in the case where the NC terminal 43 is provided between the differential signal terminals 41a and 41b like the embodiment, while a broken line represents a characteristic in a case of a conventional arrangement where no NC terminal 43 is provided. In Fig. 5, a horizontal axis represents time, and the time corresponds to a distance from the terminal of the IC package. For example, in Fig. 6, the characteristic impedance greatly fluctuates in the vicinity of 6400 µsec, and the vicinity of 6400 µsec corresponds to the vicinity of a position where the LSI chip and the connecting terminal (namely, the lead frame) are connected.

It is understood based on Fig. 5 that by providing the NC terminal 43 between the differential signal terminals 41a and 41b like the embodiment, the fluctuation in the impedance characteristic can be suppressed. Further, it is understood based on Fig. 6 that by providing the NC terminal 43 between the differential signal terminals 41a and 41b like the embodiment, the return loss can be suppressed.

As stated above, in the test on the IC package 50, the NC terminal 43 is used as a test terminal, so that various evaluations of performance for the IC package 50 can be enabled. On the other hand, in normal use of the IC package 50, the NC terminal 43 is not connected to any electric potentials, so that the return loss characteristic can be improved.

### 4. Modified Examples

Some modified examples will be described below.

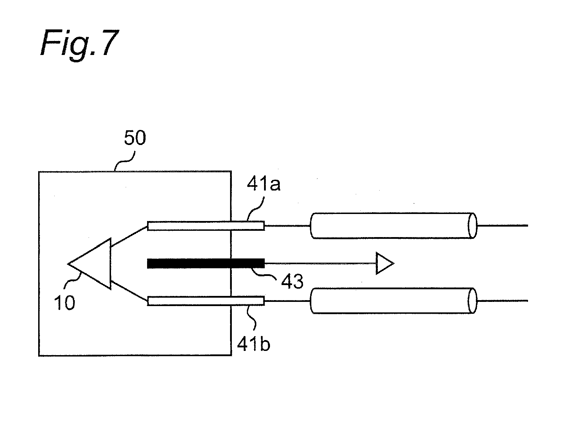

(1) In the above embodiment, the example that the NC terminal 43 is no connected to any electric potentials is described, but the NC terminal 43 may be connected to a reference potential. That is to say, at the time when the IC package 50 operates, the NC terminal 43 may be connected to the reference potential (see Fig. 7). Connecting the NC terminal 43 to the reference potential forms capacitors between the NC terminal 43 and the differential signal terminals 41a and 41b. The capacitors formed between the NC terminal 43 and the differential signal terminals 41a and 41b can release a common mode noise or ESD into a ground potential, even though the common mode noise or the ESD is input to the differential signal terminals 41a and 41b when the IC package operates, thereby preventing influence of the common mode noise or the ESD.

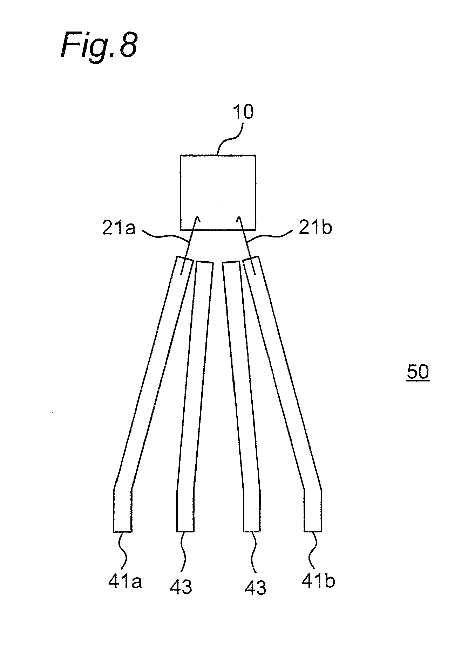

(2) In the above embodiment, the example that one NC terminal 43 is provided between the differential signal terminals 41a and 41b is described. However a plurality of NC terminals may be provided. For example, two NC terminals may be provided as shown in Fig. 8, or three or four NC terminals may be provided (in order to make the characteristic impedance 100 Ω, two or three NC terminals are preferable).

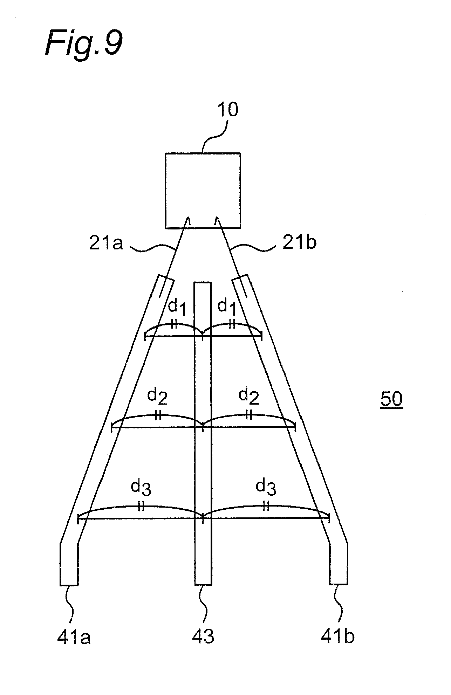

(3) Regarding the arrangement of the NC terminal 43, preferably the NC terminal 43 is arranged so that the distance between the NC terminal 43 and the differential signal terminal 41a is equal to that between the NC terminal 43 and the differential signal terminal 41b. As shown in Fig. 9, the NC terminal 43 may be arranged so that the gaps between the NC terminal 43 and the differential signal terminals 41a and 41b becomes wider from the inside of the IC package 50 towards the outside (dl < d2 < d3) with the gap between the NC terminal 43 and the differential signal terminal 41a being equal to the gap between the NC terminal 43 and the differential signal terminal 41b. By such arrangement of the NC terminal, an effect similar to a taper structure can be obtained so that an abrupt change in the characteristic impedance can be prevented.

### Second Embodiment

The first embodiment describes the example that the idea of the present invention is applied to the IC package. This embodiment describes an example that the idea of the present invention is applied to a connector.

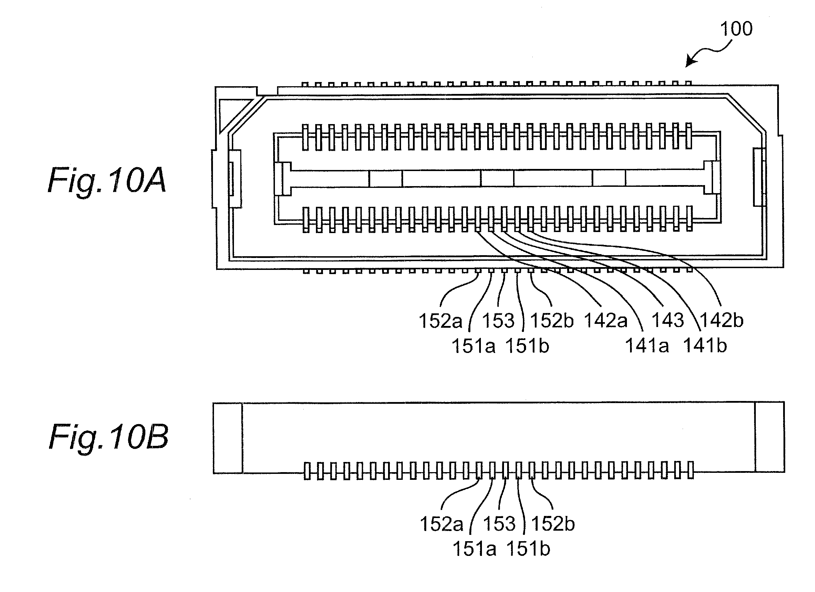

Fig. 10A is a top view illustrating the connector according to the embodiment, and Fig. 10B is a side view illustrating the connector according to the embodiment. The connector 100 according to the embodiment has an opening section to which another connector (not shown, hereinafter, referred to as "plug connector") having terminals corresponding to terminals of the connector 100 can be inserted. The connector 100 according to the embodiment is also compatible with an interface that can transmit signals at high speed using the differential signals, such as SATA (Serial-ATA) and USB 3.0.

As shown in Fig. 10A, a plurality of connecting terminals to be electrically connected to the respective terminals of the plug connector are arranged inside the opening section of the connector 100. The plurality of connecting terminals include connecting terminals 141a, 141b, 142a and 143. The connecting terminals 141a and 141b are the differential signal terminals for transmitting the differential signals (S+ and S-). The connecting terminals 142a and 142b are ground terminals connected to a reference potential. The connecting terminal 143 is the NC terminal that is not connected to any electric potentials.

Further, a plurality of connecting terminals to be electrically connected to the printed circuit board is provided outside of the connector 100 (see Figs. 10A and 10B). The connecting terminals provided outside the connector 100 are provided correspondingly to the connecting terminals arranged inside the opening section of the connector 100. The plurality of connecting terminals provided outside the connector 100 include connecting terminals 151a, 151b, 152a and 153. The connecting terminals 151a and 151b are the differential signal terminals, and are physically connected to the connecting terminals 141a and 141b provided inside the opening section. The connecting terminals 152a and 152b are ground terminals, and are connected to the connecting terminals 142a and 142b provided inside the opening section. The connecting terminal 153 is a terminal that is not connected to any electric potentials, and is physically connected to the connecting terminal 143.

In the connector 100 according to the embodiment having the above terminal structure, the impedance characteristic and the return loss characteristic can be improved by the principle similar to that of the first embodiment. Further, the terminal 153 of the connector 100 can be used as a test terminal.

The plug connector that can be inserted into the opening section of the connector 100 according to the embodiment may have terminals corresponding to the connecting terminals 141a, 141b, 142a and 143 of the connector I00. That is to say, the plug connector may have two differential signal terminals corresponding to the differential signal terminals 141a and 141b, and a terminal corresponding to the terminal 143 that is not connected to any electric potentials may be provided between the differential signal terminals.

In the fist and second embodiments, the idea of the present invention is applied to the IC package and the connector, but the present invention is not limited to them. The idea of the present invention can be applied to any apparatus having a plurality of terminals arranged and including terminals for transmitting differential signals.

### Industrial Applicability

The present invention is effective for the apparatus (the IC package or the connector and the like) having a plurality of terminals arranged and including terminals for transmitting differential signals.

### Description of Reference Signs

- 10: LSI
- 20, 21a, 21b: bonding wire
- 40, 41a, 41b, 42a, 42b, 43: lead frame (terminal)
- 50: IC package
- 60: printed circuit board
- 61: connector
- 63: signal terminal
- 100: connector
- 141a, 141b, 142a, 142b, 143: lead frame (terminal)
- 151a, 151b, 152a, 152b, 153: lead frame (terminal)

## Claims

1. An IC package comprising:
an integrated circuit for transmitting and receiving a pair of differential signals composed of a signal having positive polarity and a signal having negative polarity;
a first signal terminal for transmitting the signal having positive polarity;
a second signal terminal for transmitting the signal having negative polarity; and
a third terminal arranged between the first signal terminal and the second signal terminal, wherein
the first and second terminals are electrically connected to the integrated circuit, and
the third terminal is not electrically connected to the integrated circuit.

2. The IC package according to claim 1, wherein the third terminal is a terminal connected to a reference potential.

3. The IC package according to claim 1 or 2, wherein a plurality of the third terminals are provided.

4. The IC package according to claim 1 or 2, wherein
the first and second signal terminals and the third terminal have a portion that appears outside the IC package and a portion extending inside the IC package, respectively,
the portion of the third terminal extending inside the IC package is arranged on a position that is equally separated from the portion of the first signal terminal extending inside the IC package and the portion of the second signal terminal extending inside the IC package.

5. The IC package according to any one of claims 1 to 4, further comprising first and second ground terminals connected to a reference potential,
wherein the first and second signal terminal and the third terminal are arranged between the first ground terminal and the second ground terminal.

6. A differential signal transmission line for transmitting a pair of differential signals composed of a signal having positive polarity and a signal having negative polarity, the differential signal transmission line comprising:
a first signal terminal for transmitting the signal having positive polarity;
a second signal terminal for transmitting the signal having negative polarity; and
a third terminal that is arranged between the first signal terminal and the second signal terminal and is not connected to any electric potential.

7. The differential signal transmission line according to claim 6, further comprising first and second ground terminals connected to a reference potential,
wherein the first and second signal terminals and the third terminal are arranged between the first ground terminal and the second ground terminal.

8. The differential signal transmission line according to claim 6 or 7, wherein the third terminal is used as a test terminal in a predetermined performance test on the differential signal transmission line.

9. An IC package comprising the differential signal transmission line of any one of claims 6 to 8.

10. A connector comprising the differential signal transmission line of any one of claims 6 to 8.

11. A testing method of the differential signal transmission line of claim 8, comprising:
applying a noise signal for the test to the third terminal; and
evaluating a receiving performance when applying the noise signal to the third terminal to evaluate common mode noise immunity based on a measured signal.

12. A testing method of the differential signal transmission line of claim 8, comprising:
applying ESD to the third terminal; and
evaluating a receiving performance when applying the ESD to the third terminal to evaluate ESD immunity based on a measured signal.

13. A testing method of the differential signal transmission line of claim 8, comprising:
connecting the third terminal to a ground potential via a resistor;
applying the differential signals to the first and second signal terminals,
measuring a voltage generated at the resistor connected to the third terminal; and
evaluating skew of differential signals based on the measured voltage.

14. A testing method of the IC package of any one of claims 1 to 5, comprising:
applying a noise signal for a test to the third terminal; and
evaluating a receiving performance when applying the noise signal to the third terminal, thereby evaluating common mode noise immunity based on a measured signal.

15. A testing method of the IC package of any one of claims 1 to 5, comprising:
applying ESD to the third terminal; and
evaluating a receiving performance when applying the ESD to the third terminal, thereby evaluating ESD immunity based on a measured signal.

16. A testing method of the IC package of any one of claims 1 to 5, comprising:
connecting the third terminal to a ground potential via a resistor;
applying differential signals for a test to the first and second signal terminals;
measuring a voltage generated at the resistor connected to the third terminal; and
evaluating skew of the differential signals based on a measured voltage.
